# EUROPEAN PATENT APPLICATION

(11) **EP 1 507 022 A1**
(43) Date of publication of application: **16.02.2005**
(21) Application number: 04253493.3
(22) Date of filing: 11.06.2004
(51) Int. Cl.: C23C 14/08, C23C 28/00, C23C 30/00, F01D 5/28

(54) **Thermal barrier coating for reduced sintering and increased impact resistance, and process of making same**

(30) Priority: 14.08.2003 US 640764
(71) Applicant: GENERAL ELECTRIC COMPANY, Schenectady, NY 12345 (US)
(72) Inventor: Spitsberg, Irene, Loveland, Ohio 45140 (US); Boutwell, Brett, Liberty Township, Ohio 45011 (US); Venkataramani, Venkat S., Clifton Park, New York 12065 (US)
(74) Representative: Goode, Ian Roy

(57) **Abstract**

A composition for use as a thermal barrier coating (234) includes an at least partially stabilized zirconia matrix with a stabilizer and a pentavalent oxide dopant. A coated article (200) is disclosed for use in a high temperature a gas turbine. The coated article can include an yttria-stabilized zirconia, and a pentavalent oxide dopant. The pentavalent oxide dopant can reduce sintering of the thermal barrier coating.

## Description

This invention relates to a thermal barrier coating. More particularly, embodiments of the invention relate to an article with a thermal barrier coating which is used in the gas path environment of a gas turbine engine. In particular, an embodiment relates to a gas turbine system which includes a coated turbine blade which acts as a thermal barrier coating.

A thermal barrier coating (TBC) system may be used to protect the components of a gas turbine engine that are subjected to the highest material temperatures. The TBC system usually includes a bond coat that is deposited upon a superalloy substrate, and a ceramic TBC that is deposited upon the bond coat. The TBC acts as a thermal insulator against the heat of the hot combustion gas. The bond coat bonds the TBC to the substrate and also inhibits oxidation and corrosion of the substrate.

One currently used TBC is yttria-stabilized zirconia (YSZ), which is zirconia (zirconium oxide) with from about 3 to about 12 percent by weight yttria (yttrium oxide) added to stabilize the zirconia against phase changes that otherwise occur as the TBC is heated and cooled during fabrication and service. The YSZ is deposited by a physical vapor deposition process such as electron beam physical vapor deposition (EBPVD). In this deposition process, the grains of the YSZ form as columnar structures that extend generally outwardly from and perpendicular to the substrate and the bond coat.

To be effective, the TBC system must have a low thermal conductivity and be strongly adherent to the article to which it is bonded under contemplated use conditions. To promote adhesion and to extend the service life of a TBC system, an oxidation-resistant bond coat is usually employed. Bond coats are typically in the form of overlay coatings such as MCrAlX, where M is a transition metal such as iron, cobalt, and/or nickel, and X is yttrium or another rare earth element. Bond coats are also diffusion coatings such as simple aluminide of platinum aluminide. A notable example of a diffusion aluminide bond coat contains a platinum intermetallic, e.g. NiPtAl. When a diffusion bond coat is applied, a zone of interdiffusion forms beneath a diffusion bond coat. This zone is typically referred to as a diffusion zone.

During exposure of the ceramic TBC and subsequent exposures to high temperatures such as during ordinary service use thereof, bond coats of the type described above oxidize to form a tightly adherent alumina scale that protects the underlying structure from catastrophic oxidation.

The columnar structure of the TBC system is of particular importance to adherence of the coating and to the coating maintaining a low thermal conductivity. Beside gaps between columns, there also exists a fine porosity within subgrains in the columnar structure. The fine porosity is sometimes observed to be oriented substantially orthogonal to the columns.

As the YSZ is cycled to elevated temperatures during service, sintering creates the problems of both the large-grain, inter-columnar porosity and the subgrain, fine porosity being gradually closed. As a result, the ability of the YSZ to accommodate thermal expansion strains gradually is reduced, and the thermal conductivity of the YSZ gradually increases by about 20 percent or more.

It has been recognized that the addition of sintering inhibitors to the YSZ reduces the tendency of the gaps between the columnar grains to close by sintering during service of the thermal barrier coating. A number of sintering inhibitors have been proposed. However, these sintering inhibitors have various shortcomings, and there is a need for more effective sintering inhibitors.

Some of the physical demands of a gas turbine blade include operation in extreme environments. One condition which a gas turbine blade is subjected to is the erosive effect of small particles which pass across the turbine blade. The small particles can be generated a part of the combustion process inside a gas turbine. Another condition which a gas turbine blade is subjected to is foreign objects which come into the gas stream.

What is needed is a TBC that avoids at least some of the problems that existed in the prior art.

A component article of a gas turbine engine is disclosed. The component article is applicable to a turbine blade or turbine vane. The component article includes a body that serves as a substrate. Overlying and contacting the substrate is a thermal barrier coating system such as a bond coat. The bond coat includes an optional metal first layer that is a metal such as platinum or the like. The bond coat also includes a metal upper layer that is a metal such as aluminum or the like.

In one embodiment of the present invention, the bond coat includes a diffusion zone that is the result of interdiffusion of material from the bond coat with material from the substrate. In one embodiment, the process that deposits the metal upper layer above the substrate is performed at elevated temperature, so that during deposition, the material of the metal upper layer interdiffuses into and with the material of the substrate to form the diffusion zone.

The structure of the turbine blade is completed with a ceramic thermal barrier coating that overlies and contacts the bond coat surface and the alumina scale thereon. The ceramic thermal barrier coating includes an yttria-stabilized zirconia with at least one pentavalent oxide dopant in a concentration from about 1 mol percent to about 4 mol percent.

The bond coat includes the optional metal first layer, if present, the metal upper layer, and the alumina scale. In one embodiment, the bond coat is a diffusion aluminide bond coat that is formed by depositing an aluminum-containing metal upper layer over the substrate, and by interdiffusing the aluminum-containing metal upper layer with the substrate. In one embodiment, the bond coat is a simple diffusion aluminde. In one embodiment, the bond coat is a more complex diffusion aluminide that includes another layer such as the metal first layer. In one embodiment, the metal first layer is a platinum layer.

In one embodiment of the invention, the entire bond coat includes a platinum-aluminide diffusion aluminide. In this embodiment, a platinum-containing metal first layer is first deposited onto the surface of the substrate. In one embodiment, other metals are used in place of or in addition to the platinum to form the metal first layer.

After formation of the metal first layer, if present, the metal upper layer is deposited above the substrate, and upon the metal first layer if present, by any operable approach. In one embodiment, an alumina scale forms at the bond coat surface by oxidation of the aluminum in the bond coat.

The ceramic thermal barrier coating is deposited by a process such as physical vapor deposition process such as electron beam physical vapor deposition (EBPVD), or by the process of plasma spray deposition. In one embodiment, the ceramic thermal barrier coating is a YSZ ceramic matrix with at least one pentavalent oxide dopant added.

Examples include YSZ that has been modified with additions of a "third" oxide. In one embodiment, the "third" oxide includes a pentavalent oxide selected from vanadium oxide, tantalum oxide, niobium oxide, combinations thereof, and the like.

In one embodiment, the "third" oxide includes in addition to at least one pentavalent oxide, a trivalent oxide selected from lanthanum oxide, combinations thereof, and the like. In one embodiment, the "third" oxide includes one selected ytterbium oxide, gadolinium oxide, neodymium oxide, combinations thereof, and the like. In each enumerated embodiment, the "third" oxide is co-deposited with the YSZ.

When prepared by a PVD process, the thermal barrier coating is formed generally of a plurality of columnar grains of the ceramic material that are affixed at their roots to the bond coat and the alumina scale. In some locations of the thermal barrier coating, there are gaps that add to the insulative quality of the thermal barrier coating.

Processing is carried out by forming the optional bond coat over the substrate. Additionally, the optional platinum layer can be formed before forming the bond coat. To form the alumina scale, the bond coat can be thermally treated. The thermal barrier coating is formed by a deposition process selected from electron beam physical vapor deposition (EBPVD) and plasma spraying.

In order to understand the manner in which embodiments are obtained, a more particular description of various embodiments briefly described above will be rendered by reference to the accompanying drawings, in which:
FIG. 1 depicts a component article of a gas turbine engine such as a turbine blade or turbine vane;
FIG. 2 is a computer image cross section, through a portion of the turbine blade depicted in FIG. 1; and
FIG. 3 is a process flow diagram according to an embodiment.

The following description includes terms, such as first, second, etc. that are used for descriptive purposes only and are not to be construed as limiting. In the following detailed description, reference is made to the accompanying drawings, which form a part hereof. These drawings show, by way of illustration, specific embodiments in which the invention may be practiced. In the drawings, some of the like numerals describe substantially similar components throughout the several views. These embodiments are described in sufficient detail to enable those skilled in the art to practice the invention. Other embodiments may be used and structural changes may be made without departing from the scope of the several embodiments. Additionally, where compositions are given, if a composition is given with a percentage that is not modified by a term such as mol %, volume %, etc. it is understood that the percentage is given in weight percent.

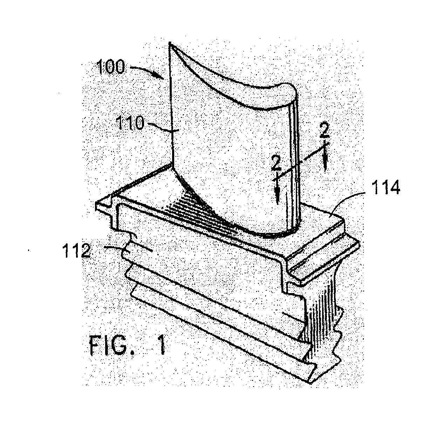

FIG. 1 depicts a component article of a gas turbine engine such as a turbine blade or turbine vane, and in this illustration a turbine blade 100. The turbine blade 100 is formed of any operable material. The turbine blade 100 includes an airfoil section 110 against which the flow of exhaust gas is directed. The turbine vane or nozzle has a similar appearance in respect to the pertinent airfoil section, but typically includes other end structure to support the airfoil. The turbine blade 100 is mounted to a turbine disk (not shown) by a dovetail 112 that extends downwardly from the airfoil 110 and engages a slot on the turbine disk. A platform 114 extends longitudinally outwardly from the area where the airfoil 110 is joined to the dovetail 112.

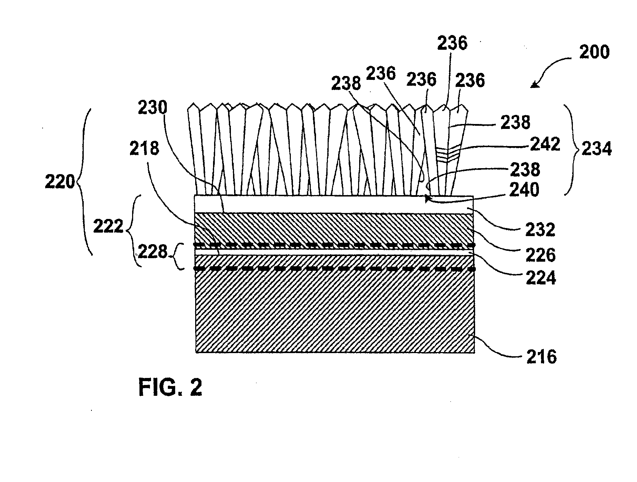

FIG. 2 is a computer image cross section, through a portion of the turbine blade 100. The turbine blade 100 is depicted in FIG. 2 as the airfoil section 110 of FIG. 1, and it is enumerated in FIG. 2 as item 200. The turbine blade 200 has a body that serves as a substrate 216 with a substrate surface 218. Overlying and contacting the substrate surface 218, and also extending downwardly into the substrate 216, is a thermal barrier coating system 220 including a protective coating 222, which in this case is termed a bond coat 222. The bond coat 222 is thin and generally planar while conforming to and being bonded to the surface 218 of the substrate 216. In one embodiment, the bond coat 222 is in a thickness range from about 0.0005 inch to about 0.0 10 inch.

In one embodiment, the bond coat 222 includes an optional metal first layer 224 that is a metal such as platinum or the like. The bond coat 222 also includes a metal upper layer 226 that is a metal such as aluminum or the like.

In one embodiment, the bond coat 222 includes a diffusion zone 228 that is the result of interdiffusion of material from the bond coat 222 with material from the substrate 216. In one embodiment, the process which deposits the metal upper layer 226 above the substrate surface 218 is performed at elevated temperature, so that during deposition, the material of the metal upper layer 226 interdiffuses into and with the material of the substrate 216, to form the diffusion zone 228. The diffusion zone 228, indicated by the dashed lines in FIG. 2, is a part of the thermal barrier coating system but it extends downward into the substrate 216.

In one embodiment, the bond coat 222 has an outwardly facing bond coat surface 230 remote from the surface 218 of the substrate 216. In one embodiment, a ceramic interface such as alumina (aluminum oxide, or Al₂O₃) scale 232 that forms at this bond coat surface 230 by oxidation of the aluminum in the bond coat 220.

The structure of the turbine blade 200 is completed with a ceramic thermal barrier coating 234 that overlies and contacts the bond coat surface 230 and the alumina scale 232 thereon. The ceramic thermal barrier coating 234 includes an yttria-stabilized zirconia with at least one pentavalent oxide dopant in a concentration from about 1 mol percent to about 4 mol percent. In one embodiment, the pentavalent oxide dopant is in a concentration from about 1.3 mol percent to about 1.9 mol percent. In one embodiment, the pentavalent oxide dopant is in a concentration from about 1.4 mol percent to about 1.8 mol percent. In one embodiment, the pentavalent oxide dopant is in a concentration of about 1.6 mol percent.

### Substrate Materials

Reference is again made to FIG. 1. In one embodiment, the component article includes a component of a gas turbine engine such as a gas turbine blade 100 or vane (or "nozzle", as the vane is sometimes called). In one embodiment, the component article includes a single crystal substrate. In one embodiment, the component article is a preferentially oriented polycrystal, or a randomly oriented polycrystal. In one embodiment, the component article is made of a nickel-base superalloy for the substrate 216 (FIG. 2). As used herein, "nickel-base" means that the composition has more nickel present than any other element.

The nickel-base superalloys are typically of a composition that is strengthened by the precipitation of gamma-prime phase or a related phase. In one embodiment, the nickel-base alloy has a composition, in weight percent, of from about 4 to about 20 percent cobalt, from about 1 to about 10 percent chromium, from about 5 to about 7 percent aluminum, from 0 to about 2 percent molybdenum, from about 3 to about 8 percent tungsten, from about 4 to about 12 percent tantalum, from 0 to about 2 percent titanium, from 0 to about 8 percent rhenium, from 0 to about 6 percent ruthenium, from 0 to about 1 percent niobium, from 0 to about 0.1 percent carbon, from 0 to about 0.01 percent boron, from 0 to about 0.1 percent yttrium, from 0 to about 1.5 percent hafnium, balance nickel and incidental impurities.

In one embodiment, an alloy composition for the substrate 216 is Rene' N5, which has a nominal composition in weight percent of about 7.5 percent cobalt, about 7 percent chromium, about 6.2 percent aluminum, about 6.5 percent tantalum, about 5 percent tungsten, about 1.5 percent molybdenum, about 3 percent rhenium, about 0.05 percent carbon, about 0.004 percent boron, about 0.15 percent hafnium, up to about 0.01 percent yttrium, balance nickel and incidental impurities.

In one embodiment, an alloy composition for the substrate 216 is Rene' N6, which has a nominal composition in weight percent of about 12.5 percent cobalt, about 4.2 percent chromium, about 1.4 percent molybdenum, about 5.75 percent tungsten, about 5.4 percent rhenium, about 7.2 percent tantalum, about 5.75 percent aluminum, about 0.15 percent hafnium, about 0.05 percent carbon, about 0.004 percent boron, about 0.01 percent yttrium, balance nickel and incidental impurities.

In one embodiment, an alloy composition for the substrate 216 is Rene' 142, which has a nominal composition, in weight percent, of about 12 percent cobalt, about 6.8 percent chromium, about 1.5 percent molybdenum, about 4.9 percent tungsten. about 6.4 percent tantalum, about 6.2 percent aluminum, about 2.8 percent rhenium, about 1.5 percent hafnium, about 0.1 percent carbon, about 0.015 percent boron, balance nickel and incidental impurities.

In one embodiment, an alloy composition for the substrate 216 is CMSX-4, which has a nominal composition in weight percent of about 9.60 percent cobalt, about 6.6 percent chromium, about 0.60 percent molybdenum, about 6.4 percent tungsten, about 3.0 percent rhenium, about 6.5 percent tantalum, about 5.6 percent aluminum, about 1.0 percent titanium, about 0.10 percent hafnium, balance nickel and incidental impurities.

In one embodiment, an alloy composition for the substrate 216 is CMSX-10, which has a nominal composition in weight percent of about 7.00 percent cobalt, about 2.65 percent chromium, about 0.60 percent molybdenum, about 6.40 percent tungsten, about 5.50 percent rhenium, about 7.5 percent tantalum, about 5.80 percent aluminum, about 0.80 percent titanium, about 0.06 percent hafnium, about 0.4 percent niobium, balance nickel and incidental impurities.

In one embodiment, an alloy composition for the substrate 216 is PWA 1480, which has a nominal composition in weight percent of about 5.00 percent cobalt, about 10.0 percent chromium, about 4.00 percent tungsten, about 12.0 percent tantalum, about 5.00 percent aluminum, about 1.5 percent titanium, balance nickel and incidental impurities.

In one embodiment, an alloy composition for the substrate 216 is PWA1484, which has a nominal composition in weight percent of about 10.00 percent cobalt, about 5.00 percent chromium, about 2.00 percent molybdenum, about 6.00 percent tungsten, about 3.00 percent rhenium, about 8.70 percent tantalum, about 5.60 percent aluminum, about 0.10 percent hafnium, balance nickel and incidental impurities.

In one embodiment, an alloy composition for the substrate 216 is MX-4, which has a nominal composition as set forth in US Patent 5,482,789, in weight percent, of from about 0.4 to about 6.5 percent ruthenium, from about 4.5 to about 5.75 percent rhenium, from about 5.8 to about 10.7 percent tantalum, from about 4.25 to about 17.0 percent cobalt, from 0 to about 0.05 percent hafnium, from 0 to about 0.06 percent carbon, from 0 to about 0.01 percent boron, from 0 to about 0.02 percent yttrium, from about 0.9 to about 2.0 percent molybdenum, from about 1.25 to about 6.0 percent chromium, from 0 to about 1.0 percent niobium, from about 5.0 to about 6.6 percent aluminum, from 0 to about 1.0 percent titanium, from about 3.0 to about 7.5 percent tungsten, and wherein the sum of molybdenum plus chromium plus niobium is from about 2.15 to about 9.0 percent, and wherein the sum of aluminum plus titanium plus tungsten is from about 8.0 to about 15.1 percent, balance nickel and incidental impurities.

The use of the foregoing embodiments is not limited to these enumerated alloys, and has broader applicability.

### Bond Coat Materials

The bond coat 222 includes the optional metal first layer 224, if present, the metal upper layer 226, and the alumina scale 232.

In one embodiment, the bond coat 222 is a diffusion aluminide bond coat which is formed by depositing an aluminum-containing metal upper layer 226 over the substrate 216, and by interdiffusing the aluminum-containing metal upper layer 226 with the substrate 216. In one embodiment, the bond coat 222 is a simple diffusion aluminde. In one embodiment, the bond coat 222 is a more complex diffusion aluminide that includes another layer such as the metal first layer 224. In one embodiment, the metal first layer 224 is a platinum layer.

Whether the bond coat 222 is a simple diffusion aluminide or a more complex diffusion aluminide, the aluminum-containing metal upper layer 226 may be doped with other elements that modify the bond coat 222. In one embodiment, the bond coat 222 includes an overlay coating known as an MCrAlX coating. The terminology "MCrAlX" is a shorthand term of art for a variety of families of overlay bond coats that may be employed as environmental coatings or bond coats in thermal barrier coating systems. In this and other forms, M refers to nickel, cobalt, iron, and combinations thereof. In some of these protective coatings, the chromium may be omitted. The X denotes elements such as hafnium, zirconium, yttrium, tantalum, rhenium, ruthenium, palladium, platinum, silicon, titanium, boron, carbon, and combinations thereof. Specific compositions are known in the art. Some examples of MCrAlX compositions include, for example, NiAlCrZr and NiAlZr, but this listing of examples is not to be taken as limiting.

In one embodiment, the entire bond coat 222 includes a platinum-aluminide diffusion aluminide. In this embodiment, a platinum-containing metal first layer 224 is first deposited onto the surface 218 of the substrate 216. In one embodiment, the platinum-containing metal first layer 224 is deposited by electrodeposition. In one embodiment, electrodeposition is accomplished by placing a platinum-containing solution into a deposition tank and depositing platinum from the solution onto the surface 218 of the substrate 216. An operable platinum-containing aqueous solution is Pt(NH₃)₄HPO₄ having a concentration of about 4-20 grams per liter of platinum, and the voltage/current source is operated at about 1/2-10 amperes per square foot of facing article surface. In one embodiment, the platinum metal first layer 224, is deposited in 1-4 hours at a temperature of 190-200°F. In one embodiment, the platinum metal first layer 224 is formed in a thickness range from about 0.00004 inch to about 0.00024 inch. In one embodiment, the platinum metal first layer 224 is about 0.0002 inch thick.

In one embodiment, other metals are used in place of or in addition to the platinum to form the metal first layer 224. Such metals and their combinations are known in the art.

After formation of the metal first layer 224, if present, the metal upper layer 226 is deposited above the substrate 216, and upon the metal first layer 224 if present, by any operable approach. In one embodiment, chemical vapor deposition (CVD) is used to form the metal upper layer 226. In that approach, a hydrogen halide activator gas, such as hydrogen chloride, is contacted with aluminum metal or an aluminum alloy to form the corresponding aluminum halide gas. Halides of any modifying elements are formed by the same technique. The aluminum halide (or mixture of aluminum halide and halide of the modifying element, if any) contacts the platinum-containing metal first layer 224 that overlies the substrate 216, depositing the aluminum thereon. In one embodiment, the deposition occurs at elevated temperature such as from about 1,825°F to about 1,975°F so that the deposited aluminum atoms interdiffuse into the substrate 216 during a 4 to 20 hour cycle.

In one embodiment, an alumina (aluminum oxide, or Al₂O₃) scale 232 forms at this bond coat surface 230 by oxidation of the aluminum in the bond coat 220 at the bond coat surface 230. Where the metal upper layer is a complex aluminum compound, a modified "alumina" scale 232 correspondingly forms the scale 232.

### Thermal Barrier Coatings

The ceramic thermal barrier coating 234 is deposited by a process such as physical vapor deposition process such as electron beam physical vapor deposition (EBPVD), or by the process of plasma spray deposition. In one embodiment, the ceramic thermal barrier coating 234 has a thickness from about 0.003 inch to about 0.010 inch thick. In one embodiment, the ceramic thermal barrier coating 234 has a thickness of about 0.005 inch thick.

In one embodiment, the ceramic thermal barrier coating 234 is a YSZ, which is zirconium oxide containing from about 3 to about 12 weight percent. In one embodiment, the ceramic thermal barrier coating 234 is from about 4 to about 8 weight percent, of yttrium oxide. Additionally, at least one pentavalent oxide dopant is added.

Examples include YSZ that has been modified with additions of a "third" oxide. In one embodiment, the "third" oxide includes a pentavalent oxide selected from tantalum oxide, niobium oxide, combinations thereof, and the like.

In one embodiment, the "third" oxide includes in addition to at least one pentavalent oxide, a trivalent oxide such as lanthanum oxide, and the like. In one embodiment, the "third" oxide includes one selected ytterbium oxide, gadolinium oxide, neodymium oxide, combinations thereof, and the like. In each enumerated embodiment, the "third" oxide is co-deposited with the pentavalent oxide and the YSZ.

In one embodiment, the ceramic thermal barrier coating 234 includes a ceramic matrix of a doped zirconia with the addition of at least one pentavalent oxide. In one embodiment, the zirconia ceramic matrix is at least partially stabilized with calcia and the addition of at least one pentavalent oxide. In one embodiment, the zirconia ceramic matrix is at least partially stabilized with magnesia and the addition of at least one pentavalent oxide. In one embodiment, the zirconia ceramic matrix is at least partially stabilized with ceria and the addition of at least one pentavalent oxide. In one embodiment, the zirconia ceramic matrix is at least partially stabilized with a combination of at least two of the above stabilizers and the addition of at least one pentavalent oxide.

In one embodiment, the zirconia ceramic matrix includes YSZ with about 4 to about 8% by weight of yttria (which can be referred to as 4-8 YSZ). In this embodiment, the 4-8 YSZ matrix includes a pentavalent oxide dopant in a concentration from about 1 mol percent to about 4 mol percent. In one embodiment, the 4-8 YSZ matrix includes a pentavalent oxide dopant in a concentration of about 1.6 mol percent.

In one embodiment, the pentavalent oxide includes tantala, Ta₂O₅. In one embodiment, the pentavalent oxide includes tantala in a major amount and at least one other pentavalent oxide such as niobia or niobium oxide. In an alternative embodiment, the pentavalent oxide includes a tantalum oxide as a non-stoichiometric solid solution within the ceramic matrix. In another alternative embodiment, the pentavalent oxide includes a tantalum oxide in a major amount as a non-stoichiometric solid solution within the ceramic matrix, and at least one other pentavalent oxide such as niobia or niobium oxide. In one embodiment, the pentavalent oxide includes tantala in a range from about 1 mol % to about 4 mol %. In one embodiment, the pentavalent oxide includes tantala in a range from about 1.3 mol % to about 1.9 mol %. In one embodiment, the pentavalent oxide includes tantala in a range from about 1.4 mol % to about 1.8 mol %. In one embodiment, the pentavalent oxide includes about 1.6 mol % tantala in a 7 YSZ ceramic matrix.

In one embodiment, the pentavalent oxide includes niobia, Nb₂O₅. In one embodiment, the pentavalent oxide includes niobia in a major amount and at least one other pentavalent oxide such as tantala or tantalum oxide. In an alternative embodiment, the pentavalent oxide includes a niobium oxide as a non-stoichiometric solid solution within the ceramic matrix. In another alternative embodiment, the pentavalent oxide includes a niobium oxide in a major amount as a non-stoichiometric solid solution within the ceramic matrix, and at least one other pentavalent oxide such as tantala or tantalum oxide.

In one embodiment, the pentavalent oxide includes niobia in a range from about 1 mol % to about 4 mol %. In one embodiment, the pentavalent oxide includes niobia in a range from about 1.2 mol % to about 1.8 mol %. In one embodiment, the pentavalent oxide includes about 1.6 mol % niobia in a 7 YSZ ceramic matrix.

The thermal barrier coating 234 can include one of the various ceramic matrix embodiments that are set forth herein. In one embodiment, yttria in the thermal barrier coating 234 is present in an amount of about 7%. The pentavalent oxide is selected from Ta₂O₅, tantalum oxide, Nb₂O₅, niobium oxide, and a combination thereof, and is present in a range from about 1 mol % to about 4 mol %. In one embodiment, the pentavalent oxide is selected from Ta₂O₅, tantalum oxide, Nb₂O₅, niobium oxide, and a combination thereof, and is present in a range from about 1.3 mol % to about 3 mol %. In one embodiment, the pentavalent oxide is selected from Ta₂O₅, tantalum oxide, Nb₂O₅, niobium oxide, and a combination thereof, Ta₂O₅, tantalum oxide, Nb₂O₅, niobium oxide, and a combination thereof, and is present in a range from about 1.5 mol % to about 2 mol %. In one embodiment, the pentavalent oxide is selected from Ta₂O₅, tantalum oxide, Nb₂O₅, niobium oxide, and a combination thereof, and is present at about 1.6 mol %.

As illustrated schematically in FIG. 2, when prepared by a PVD process, the thermal barrier coating 234 is formed generally of a plurality of columnar grains 236 of the ceramic material that are affixed at their roots to the bond coat 222 and the alumina scale 232. The columnar grains 236 have grain surfaces 238. In some locations of the thermal barrier coating 234, there are gaps 240, whose size is exaggerated in FIG. 2 for the purposes of illustration, between the grains 236 and their facing grain surfaces 238.

In one embodiment, the ceramic thermal barrier coating 234 is formed by EBPVD that forms a subgrain 242. The subgrain 242 is illustrated schematically in a selected portion of some of the columnar grains 236. In FIG. 2, the subgrain 242 includes a subgrain boundary and a subgrain body. The subgrain boundary is depicted schematically as a diagonal line. The subgrain body is depicted schematically as the space between two diagonal lines.

This morphology of the thermal barrier coating 236 including the columnar grains 236 with their corresponding gaps 240 and the subgrains 242 is beneficial to the functioning of the thermal barrier coating 236. The gaps 240 allow the substrate 216, the bond coat 222 including the alumina scale 232, and the thermal barrier coating 234 to expand and contract without significantly damaging morphological changes therein. Because the thermal barrier coating 234 is a ceramic material, it has a generally low ductility so that the accumulated stresses would be likely to cause failure. With the gaps 240 present, however, the in-plane stresses in the thermal barrier coating 236 are developed across only one or at most a group of a few of the columnar grains 236. That is, all of the columnar grains 236 have in-plane stresses, but the magnitude of the in-plane stresses are relatively low because the strains do not accumulate over long distances. The result is that the thermal barrier coating 234 with the columnar grains 236 and gaps 240 is less likely to fail by in-plane overstressing during service. Additionally, the gaps 240 are filled with air, which when relatively stagnant between the grains 236 is an effective thermal insulator, aiding the thermal barrier coating 234 in performing its primary role.

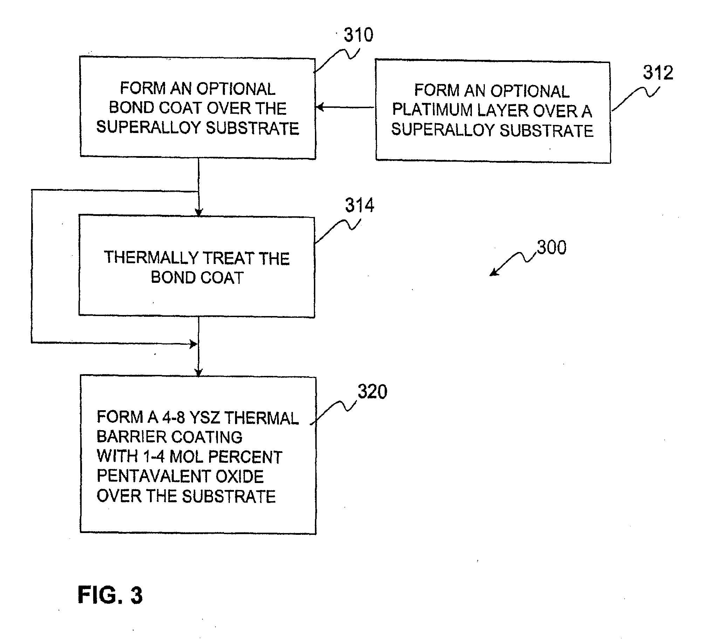

FIG. 3 is a block diagram of a process embodiment. The process 300 includes forming the thermal barrier coating, and optionally forming the bond coating.

At 310, an optional bond coat is formed over the substrate.

At 312, the optional platinum layer is formed before forming the bond coat.

At 314, the bond coat is optionally thermally treated to form the "alumina" scale 232 as set forth herein according to several embodiments.

At 320, the thermal barrier coating is formed by a deposition process selected from EBPVD and plasma spraying.

### Example 1

An EB-PVD technique was used to form a coating on a substrate. The coating was 7 YSZ that included about 1.6 mol % of Ta₂O₅. After the TBC was applied, thermal cycling (TC) was done to obtain a metric on sintering resistance. The coating was heated to about 1,200° C for about 2 hours in air. After the thermal cycling, the coated substrate had an observed change in thermal conductivity from about 1.58 W/m K before TC to about 1.64 W/m K after TC, respectively. Evaluation of the thermal conductivity was conducted by the laser flash method known in the art.

### Example 2

An EB-PVD technique is used to form a coating on a substrate. The coating is a 4-8 YSZ that includes a pentavalent oxide dopant in a concentration from about 1 mol percent to about 4 mol percent. After forming the coating on the substrate, the coating on the substrate is exposed to about 1,200° C for about 2 hours in air to obtain a metric on sintering resistance. After the heat treating of the coating, thermal conductivity of the coating has increased from about 2% to about 10%. In one embodiment, thermal conductivity of the coating has increased more than 10%, but less than about 20%.

### Example 3

An EB-PVD technique is used to form a coating on a substrate. The coating is a 7 YSZ that includes a pentavalent oxide dopant in a concentration from about 1.2 mol percent to about 2.2 mol percent. After forming the coating on the substrate, the coating on the substrate is exposed to about 1,200° C for about 2 hours in air to obtain a metric on sintering resistance. After the heat treating of the coating, thermal conductivity of the coating has increased from about 2% to about 9%.

### Comparative Example

An EB-PVD technique was used to form a coating on a substrate. The coating was a 7 YSZ. After the TBC was applied, TC was done by heating the coating to about 1,200° C for about 2 hours in air. Seven baseline samples were so processed, and an average of their tests was taken for the baseline numbers. After the TC the coated substrate had an observed change in thermal conductivity from about 1.53 W/m K to about 2.02 W/m K.

### Gas Turbines

In one embodiment, a system is disclosed that includes a gas turbine. In one embodiment, the gas turbine includes a composition and structure similar to the computer drawing depicted in FIG. 2. In one embodiment, the gas turbine includes a coated article according to embodiments set forth in this disclosure such as is depicted in FIG 2. In one embodiment, the gas turbine includes a turbine blade according to embodiments set forth in this disclosure such as is depicted in FIG 1.

## Claims

1. A composition comprising:
a ceramic matrix including an at least partially stabilized zirconia and at least one pentavalent oxide dopant in a concentration from about 1 mol percent to about 4 mol percent.

2. The composition according to claim 1, wherein the at least at least one pentavalent oxide dopant is in a concentration from about 1.3 mol percent to about 1.89 mol percent.

3. The composition according to claim 1, wherein the at least partially stabilized zirconia includes yttria in a range from about 4 % to about 8 %.

4. The composition according to claim 1, wherein the pentavalent oxide is selected from tantalum oxide, niobium oxide, and combinations thereof.

5. A coated article, comprising:
a superalloy substrate;
a bond coat disposed above the superalloy substrate;
a ceramic interface disposed above the bond coat; and
a thermal barrier coating disposed above the ceramic interface including an yttria-stabilized zirconia (YSZ) and a pentavalent oxide dopant in a concentration from about 1 mol percent to about 4 mol percent.

6. The coated article according to claim 5, wherein the pentavalent oxide is selected from Ta₂O₅, tantalum oxide, Nb₂O₅, niobium oxide, and a combination thereof, and wherein the pentavalent oxide is present in a range from about 1.3 mol % to about 1.9 mol %.

7. A coated turbine blade comprising:
a turbine blade substrate including a superalloy;
a turbine blade coating above the turbine blade substrate, wherein the coating is a composition including an yttria-stabilized zirconia (YSZ) matrix and a pentavalent oxide dopant in a concentration from about 1 mol percent to about 4 mol percent.

8. The coated turbine blade according to claim 7, wherein the turbine blade coating includes a bond coat including aluminum, and wherein the pentavalent oxide dopant includes tantala in a range from about 1.3 mol% to about 1.9 mol%.

9. The coated turbine blade according to claim 7, wherein the turbine blade coating includes a bond coat including aluminum, and wherein the pentavalent oxide dopant includes niobia in a range from about 1.3 mol% to about 1.9 mol%.

10. A system comprising:
a gas turbine, and within the gas turbine a turbine blade, including:
a superalloy substrate;
a bond coating disposed above the superalloy substrate;
a ceramic interface disposed above the bond coating; and
a thermal barrier coating disposed above the ceramic interface including an yttria-stabilized zirconia (YSZ) and a pentavalent oxide dopant in a concentration from about 1 mol percent to about 4 mol percent.
